# EUROPEAN PATENT APPLICATION

(11) **EP 2 899 837 A1**
(43) Date of publication of application: **29.07.2015**
(21) Application number: 13839676.7
(22) Date of filing: 19.09.2013
(51) Int. Cl.: H02J 7/00, G01R 31/36, H01M 10/42

(54) **ACCUMULATOR OPERATION CONTROL DEVICE, ACCUMULATOR OPERATION CONTROL METHOD, AND PROGRAM**

(30) Priority: 20.09.2012 JP 2012206504
(71) Applicant: Sekisui Chemical Co., Ltd., Osaka-shi, Osaka 530-8565 (JP)
(72) Inventor: NAKAMORI Yuichi, Tsukuba-shi Ibaraki 300-4292 (JP); HANTANI Hiroshi, Tsukuba-shi Ibaraki 300-4292 (JP); ATAKA Motoharu, Tsukuba-shi Ibaraki 300-4292 (JP)
(74) Representative: Müller-Boré & Partner Patentanwälte PartG mbB
(86) International application number: PCT/JP2013/075299
(87) International publication number: WO 2014/046179

(57) **Abstract**

The apparatus for controlling operation of a storage battery of the present invention comprises: a component deterioration index measuring part, which measures a deterioration index with respect to each of predetermined components of a storage battery; a deterioration condition determination part, which determines deterioration condition with respect to each of the predetermined components, based on the deterioration indices of the components measured by the component deterioration index measuring part; an operation condition determination part, which determines such an operation condition of the storage battery as would cause deterioration of each component to progress in a manner such that the longest battery life is achieved, based on the deterioration conditions determined by the deterioration determination part; and an operation control part for operating the storage battery based on the operation condition determined by the operation condition determination part.

## Description

### TECHNICAL FIELD

The present invention relates to an apparatus for controlling operation of a storage battery, and a method and a program for controlling operation of a storage battery.

Priority is claimed on Japanese Patent Application No. 2012-206504, filed September 20, 2012, the contents of which are incorporated herein by reference.

### BACKGROUND ART

With respect to storage batteries (secondary batteries) such as a lithium ion battery which is a representative example of the storage batteries, the deterioration of the batteries proceed in the course of use thereof due to factors such as repeated charge/discharge cycles and extended storage time of the batteries. Therefore, for using the storage batteries, it is important to grasp the deterioration condition of the storage batteries.

For example, as described in Patent Document 1, a technique to measure the inside impedance of the storage batteries is known. As generally known, the deterioration of the storage batteries can be determined by measuring the inside impedance of the storage batteries.

Further, as described in Patent Document 2, there is also known an electronic device which notifies the degree of deterioration of the battery portion determined based on the change of inside impedance of the battery portion. This enables an efficient management such as battery replacement.

### CITATION LIST

### PATENT DOCUMENTS

Patent Document 1: Japanese Patent No. 4360621
Patent Document 2: Japanese Unexamined Patent Application Publication No. 2005-108491

### DISCLOSURE OF INVENTION

### PROBLEMS TO BE SOLVED BY THE INVENTION

For example, if storage batteries can be operated such that the life of storage batteries can be extended as much as possible by grasping the deterioration condition of the batteries, operation cost or burden on environment can be favorably reduced.

However, at present, as in the case of Patent Document 2, the results of the determination of the deterioration of the storage batteries are utilized only for management of the storage batteries such as judgment of timing for battery replacement.

The present invention has been made in view of these situations, and the purpose of the present invention is to enable the operation control which extends the life of a storage battery, based on the results of the determination of the deterioration condition of the battery.

### MEANS TO SOLVE THE PROBLEMS

For solving the aforementioned problems, the present invention in the first embodiment thereof provides an apparatus for controlling operation of a storage battery (hereinafter, sometimes referred to as "battery operation control apparatus"), which comprises: a component deterioration index measuring part, which measures a deterioration index with respect to each of predetermined components of a storage battery; a deterioration condition determination part, which determines deterioration condition with respect to each of the predetermined components, based on the deterioration index of each of the components measured by the component deterioration index measuring part; an operation condition determination part, which determines operation condition of the storage battery such that the degree of the deterioration of each of the components of the battery is such that the longest battery life is achieved, based on the deterioration conditions determined by the deterioration determination part; and an operation control part for operating the storage battery based on the operation condition determined by the operation condition determination part.

The present invention in the second embodiment thereof provides the battery operation control apparatus wherein the components of the storage battery in the first embodiment are a positive electrode, a negative electrode and an electrolyte.

The present invention in the third embodiment thereof provides the battery operation control apparatus wherein, in the first or second embodiment, the component deterioration index measuring part measures resistance with respect to each of the components, the deterioration condition determination part sorts the components into a target of the deterioration control and a non-target of the deterioration control for determining the deterioration condition of each of the components, based on the resistance of each of the components measured by the component deterioration index measuring part, the operation condition determination part identifies an operation condition correlated with a combination of the component as target of the deterioration control and the component as non-target of the deterioration control, which are determined by the deterioration condition determination part, based on an operation condition table which correlates each combination of the component as target of the deterioration control and the component as non-target of the determination control with an operation condition, wherein the identified operation condition is regarded as the result of the determination.

The present invention in the fourth embodiment provides the battery operation control apparatus, wherein, in the first or second embodiment, the component deterioration index measuring part measures resistances of the storage battery with respect to the components; the deterioration condition determination part determines an amount of resistance change from the initial value, as the deterioration condition of each of the components, with respect to the resistance of each of the components measured by the component deterioration index measuring part; and the operation condition determination part, referring to an operation condition table showing correlations between operation conditions and resistance change ratios obtainable under the respective operation conditions, selects from the table candidates of the resistance change ratio at which the degree of deterioration of each component is such that the life of the battery can be extended, based on resistance change ratios each being a ratio of the amounts of resistance change of the components determined by the deterioration condition determination part, and a resistance change ratio corresponding to such an operation condition of the storage battery that the longest battery life is achieved, and selects an operation condition, as a determination result, which is the closest to an ongoing operation condition, from the operation conditions correlated to the candidates of the resistance change ratio.

The fifth embodiment of the present invention is a method for controlling operation of a storage battery, which comprises: a component deterioration index measuring step for measuring a deterioration index with respect to each of predetermined components of a storage battery, a deterioration condition determination step for determining deterioration condition with respect to each of the predetermined components, based on the deterioration indices of the components measured in the component deterioration index measuring step, an operation condition determination step for determining an operation condition of the storage battery at which the degree of deterioration of each of the components of the battery is such that the longest battery life is achieved, based on the deterioration conditions determined in the deterioration determination step, and an operation control step for operating the storage battery based on the operation condition determined in the operation condition determination step.

The sixth embodiment of the present invention is a computer program for implementing: a component deterioration index measuring step for measuring a deterioration index with respect to each of predetermined components of a storage battery, a deterioration condition determination step for determining deterioration condition with respect to each of the predetermined components, based on the deterioration indices of the components measured in the component deterioration index measuring step, an operation condition determination step for determining an operation condition of the storage battery at which the degree of deterioration of each of the components of the battery is such that the longest battery life is achieved, based on the deterioration conditions determined in the deterioration determination step, and an operation control step for operating the storage battery based on the operation condition determined in the operation condition determination step.

### EFFECT OF THE INVENTION

The apparatus and method of the present invention for controlling operation of a storage battery and the program of the present invention are advantageous in that a battery operation can be controlled such that the life of a storage battery can be extended utilizing the results of the determination of the deterioration condition of the battery.

### BRIEF DESCRIPTION OF THE DRAWINGS

FIG. 1 shows an example of construction of a power management system according to the first embodiment of the present invention.
FIG. 2 shows an example of construction of the battery operation control apparatus according to the first embodiment of the present invention.
FIG. 3 shows an operating principle of a storage battery during charge thereof.
FIG. 4 shows an operating principle of a storage battery during discharge thereof.
FIG. 5 shows an equivalent circuit used by the component deterioration index measuring part in the first embodiment of the present invention, which measures a resistance of each of a positive electrode, a negative electrode and an electrolyte in accordance with the alternating current impedance method.
FIG. 6 shows an example of construction of an operation condition table according to the first embodiment of the present invention.
FIG. 7 shows an example of progress of deterioration of components during operation control by the battery operation control apparatus according to the first embodiment of the present invention.
FIG. 8 is a flowchart showing an example of procedures implemented by the battery operation control apparatus according to the first embodiment of the present invention.
FIG. 9 shows an example of construction of the battery operation control apparatus according to the second embodiment of the present invention.
FIG. 10 shows an equivalent circuit used by the component deterioration index measuring part in the second embodiment of the present invention, which measures a resistance of each of a positive electrode, a negative electrode and an electrolyte in accordance with the alternating current impedance method.
FIG. 11 shows examples of operation conditions of an operation test for preparation of an operation condition table in the second embodiment of the present invention and contents of the test results corresponding to the operation conditions.
FIG. 12 shows more specifically the contents of the test results shown in FIG. 11.
FIG. 13 shows the results of measurements of capacity maintenance ratios and amounts of resistance change with respect to an electrolytic solution, a negative electrode and a positive electrode in a test performed following operation conditions of a certain cycle operation.
FIG. 14 shows an example of construction of an operation condition table according to the second embodiment of the present invention.
FIG. 15 is a flowchart showing an example of procedures implemented by the battery operation control apparatus according to the second embodiment of the present invention.

### EMBODIMENTS FOR CARRYING OUT THE INVENTION

### <First embodiment>

### [Example of construction of power management system]

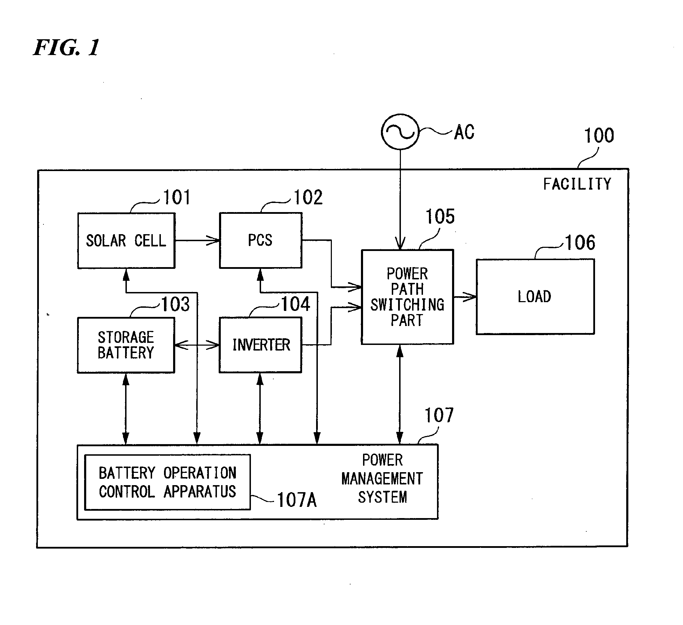

FIG. 1 shows an example of construction of a power management system according to the first embodiment of the present invention.

The power management system shown in this drawing is for example a system for managing electric power used in one facility 100 and corresponds to what is called HEMS (Home Energy Management System).

The facility 100 is, for example, any one of residential houses, commercial facilities, industrial facilities and public facilities.

The facility 100 shown in FIG. 1 has a solar cell 101, a power conditioning system (PCS) 102, a storage battery 103, an inverter 104, a power path switching portion 105, a load 106 and a power management apparatus 107.

The solar cell 101 is a power generation apparatus (photovoltaic power generation apparatus) which converts light energy into electricity by photovoltaic effect. The solar cell 101 is provided at a place which can efficiently receive sunlight, such as a roof of the facility 100, and converts the sunlight into electric power.

The power conditioning system 102 converts a direct current power output from the solar cell 101 into alternating current.

The storage battery 103 stores electricity input by charging and output stored electricity by discharging. As the storage battery 103, for example, a lithium ion battery can be used.

The inverter 104 is provided with respect to each of the storage batteries 103 ,and converts electricity to be charged to the storage battery 103 from alternating current to direct current or converts electricity discharged from the storage battery 103 from direct current to alternating current. That is, the inverter performs bidirectional conversion of electricity input to or output from the storage battery 103.

Specifically, when the storage battery 103 is charged, an alternating current power for charging is supplied to the inverter 104 from a commercial power supply AC or a power conditioning system 102 via a power path switching portion 105. The inverter 104 converts the alternating current power thus supplied to a direct current power, and supplies the power to the storage battery 103.

Further, when the storage battery 103 discharges, a direct current power is output from the storage battery 103. The inverter 104 converts the direct current power thus output from the storage battery 103 to an alternating current power, and supplies the power to the power path switching portion 105.

The power path switching portion 105 switches the power path via the control by the power management apparatus 107. Due to the aforementioned control, the power path switching portion 105 can form a power path such that a power from the commercial power supply AC is supplied to a load 106 in the facility 100.

The power path switching portion 105 can also form a power path such that a power generated in the solar cell 101 is supplied through the power conditioning system 102 to the load 106 in the facility 100.

The power path switching portion 105 can also form a power path such that a power supplied from one or both of the commercial power supply AC and the solar cell 101 is charged to the storage battery 103 through the inverter 104 in the facility 100.

The power path switching portion 105 can also form a power path such that a power output from the storage battery 103 by discharging is supplied through the inverter 104 to the load 106 in the facility 100.

The load 106 comprehensively indicates devices, equipment etc. which consume electric power for their own operation in the facility 100.

The power management system 107 manages power in the facility 100. For this purpose, the power management system 107 controls electric equipment (all or a part of the solar cell 101, the power conditioning system102, the storage battery 103, the inverter 104, the power path switching portion 105 and the load 106) in the facility 100. Further, the power management system 107 has a function as a battery operation control apparatus 107A which controls operation of the storage battery 103.

### [Example of construction of battery operation control apparatus]

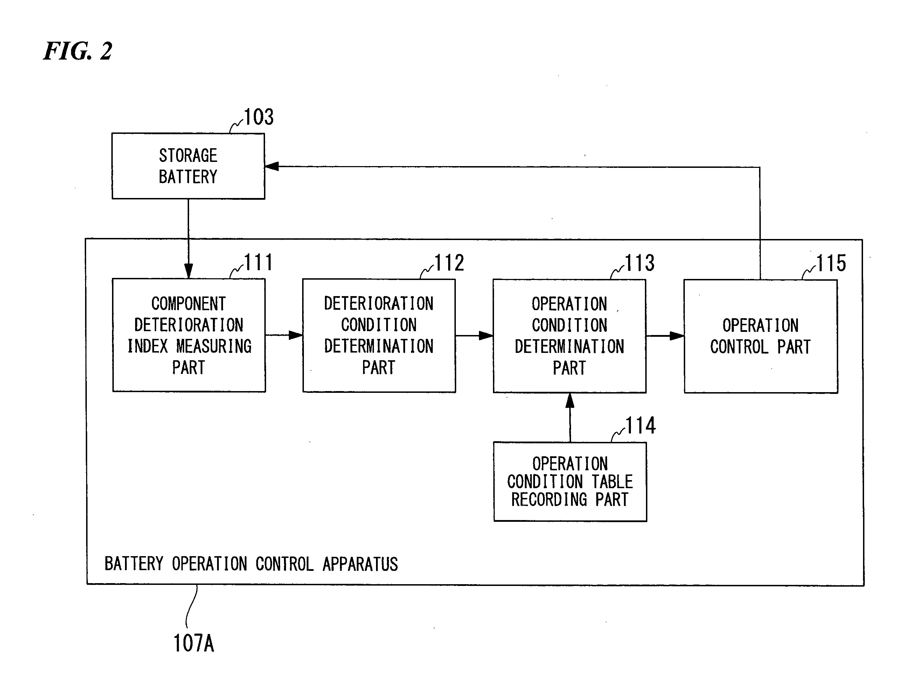

FIG. 2 shows an example of construction of the battery operation control apparatus 107A according to the first embodiment of the present invention.

The battery operation control apparatus 107A shown in Fig. 2 has a component deterioration index measuring part 111, a deterioration condition determination part 112, an operation condition determination part 113, an operation condition table recording part 114 and an operation control part 115.

The component deterioration index measuring part 111 measures a deterioration index with respect to each of predetermined components of the storage battery.

In this embodiment, the components subjected to measurements by the component deterioration index measuring part 111 are, for example, a positive electrode, a negative electrode and an electrolyte of the storage battery 103. The deterioration index means an index used for determination of deterioration. The component deterioration index measuring part 111 in this embodiment measures, as deterioration indices, resistances corresponding to the positive electrode, the negative electrode and the electrolyte among the resistances of the storage battery.

The deterioration condition determination part 112 determines deterioration conditions with respect to the components, based on the deterioration indices of the components measured by the component deterioration index measuring part 111.

The operation condition determination part 113 determines such an operation condition of the storage battery 103 as would cause deterioration of each component to progresses in a manner such that the longest battery life is achieved, based on the deterioration conditions determined by the deterioration determination part 112.

For determining the operation condition, the operation condition determination part 113 refers to the operation condition table recording part 114.

The operation condition table recording part 114 records the operation condition table. The operation condition table stores data on the operation conditions corresponding to the combinations of deterioration conditions of the components. The operation conditions herein indicate prescribed conditions required for operating the storage battery 103.

For example, a certain operation condition indicates a condition requiring that the storage battery 103 should be operated such that the number of charge/discharge cycle per unit time at a temperature below a predetermined value does not exceed a predetermined value. Another certain operation condition may indicate a condition requiring that the storage battery 103 should be operated such that the storage time (time interval between completion of charge and initiation of next discharge) per unit time at a temperature above a predetermined value does not exceed a predetermined value.

The operation condition determination part 113 identifies an operation condition stored in correspondence with the combinations of deterioration conditions of the components determined by the deterioration condition determination part 112 from among the operation conditions stored in the operation condition table. The operation condition determination part 113 output the identified operation condition as a result of the determination.

The operation control part 115 operates the storage battery 103 based on the operation condition determined by the operation condition determination part 113.

### [Operating principle of storage battery]

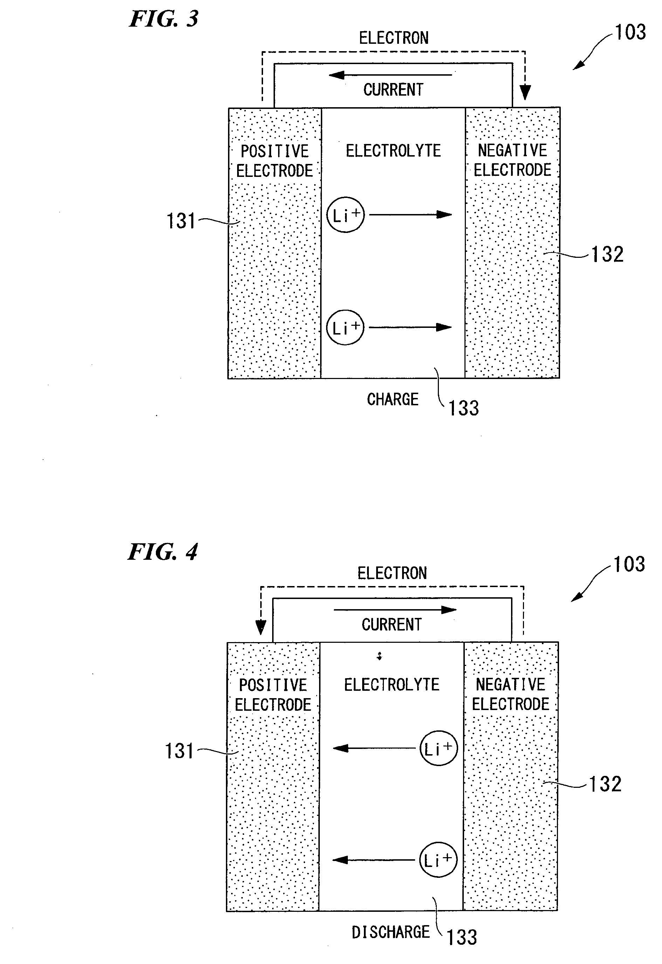

FIGs. 3 and 4 schematically show operating principles of the storage battery 103. FIG. 3 shows an operating principle of the battery during charge thereof, and FIG. 4 shows an operating principle of the battery during discharge thereof. FIGs. 3 and 4 relate to an example where the storage battery 103 is a lithium ion battery.

As shown in FIGs. 3 and 4, the storage battery 103 has a positive electrode 131, a negative electrode 132 and an electrolyte 133 as components thereof. At present, various materials can be used for the positive electrode 131, the negative electrode 132 and the electrolyte 133. As most typical examples, there can be mentioned lithium cobalt oxide for the positive electrode 131, graphite for the negative electrode 132 and an organic solvent mixed with a supporting electrolyte such as lithium perchlorate for the electrolyte 133.

As shown in FIG. 3, the lithium compound in the positive electrode 131 is separated and converted to a lithium ion during charge of the storage battery 103. Then, the lithium ion migrates to the negative electrode 132 through the electrolyte 133. The lithium ion which has reached the negative electrode 132 is then donated with an electron to become a lithium atom and is stored in the negative electrode 132.

As shown in FIG. 4, during the discharge of the storage battery 103, the lithium atom donates an electron to the negative electrode 132 to become a lithium ion which, then, migrates to the positive electrode 131 through the electrolyte 133. Then, the lithium ion which has reached the positive electrode 131 is donated with an electron to become a lithium compound and is stored in the positive electrode 131.

Thus, in the storage battery 103 as a lithium ion battery, a lithium ion migrates between the positive electrode 131 and the negative electrode 132 through the electrolyte 133, and the charge/discharge are carried out by the conversion between a lithium atom and a lithium ion in the positive electrode 131 and the negative electrode 132.

These positive electrode 131, negative electrode 132 and electrolyte 133 deteriorate as the number of charge/discharge cycle increases and the storage time becomes longer. For example, in the case of Patent Document 1, it can be said that this document determines the deterioration condition encompassing the deteriorations of these positive electrode 131, negative electrode 132 and electrolyte 133 based on the results of the measurement of the inside impedance of the battery.

However, with respect to the positive electrode 131, the negative electrode 132 and the electrolyte 133, as viewed individually, the progress of deterioration under a certain operation condition is not necessarily the same among these components. The reason for this is that the condition which promotes deterioration differs among the positive electrode 131, the negative electrode 132 and the electrolyte 133.

For example, when one of the positive electrode 131, the negative electrode 132 and the electrolyte 133 deteriorates markedly more than the other components and the life thereof ends earlier than the other components, the life of the storage battery 103 itself also ends even if the other components are not so seriously deteriorated. This alternatively means that, for example, when the storage battery 103 is operated in such a manner as would prevent a specific one of the components (the positive electrode 131, the negative electrode 132 and the electrolyte 133) from deteriorating faster than the other components, this would result in a longer life of the storage battery 103.

In view of the above, the battery operation in this embodiment is controlled so as to bring the deterioration progresses of the electrolyte 133, the negative electrode 132 and the positive electrode 131 close to those whereby the battery life can be extended the most, based on the results of the measurement of deterioration conditions with respect to the positive electrode 131, the negative electrode 132 and the electrolyte 133. Thus, a long life of the storage battery 103 can be achieved. Hereinbelow, the construction of this embodiment for this purpose is explained.

### [Examples of deterioration index measurement]

The component deterioration index measuring part 111 in this embodiment measures resistances as respective deterioration indices of the positive electrode 131, the negative electrode 132 and the electrolyte 133. Therefore, the component deterioration index measuring part 111 measures respective resistances of the positive electrode 131, the negative electrode 132 and the electrolyte 133. For this purpose, the component deterioration index measuring part 111 measures, for example, the resistance (impedance) of each of the positive electrode 131, the negative electrode 132 and the electrolyte 133 in accordance with the alternating current impedance method.

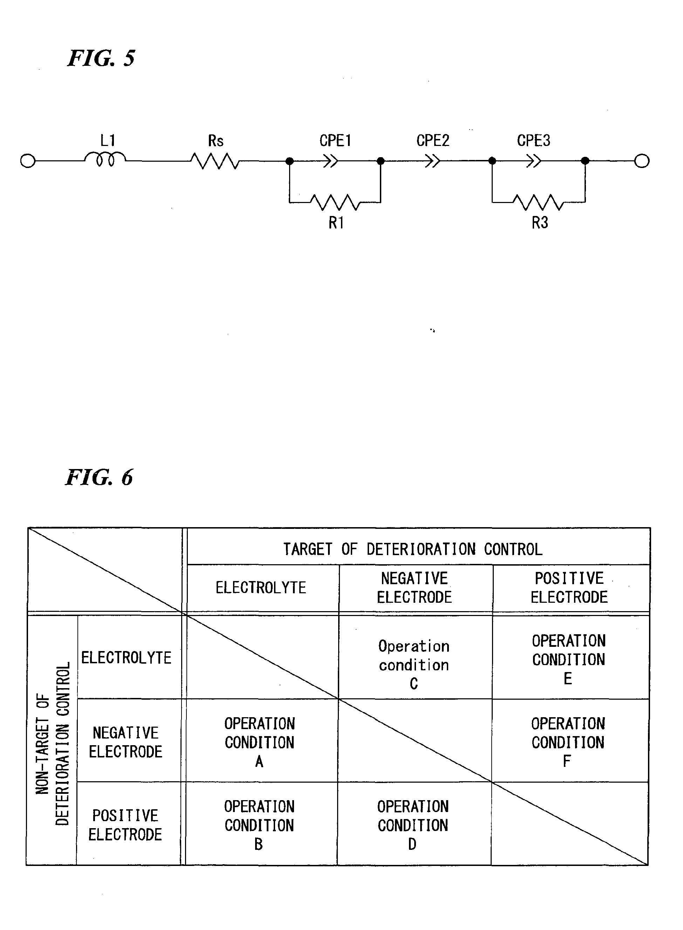

FIG. 5 shows an equivalent circuit used by the component deterioration index measuring part 111, which measures respective resistances of the positive electrode 131, the negative electrode 132 and the electrolyte 133 in accordance with the alternating current impedance method.

The equivalent circuit shown in FIG. 5 serially connects an inductance LI, a resistor Rs, a constant phase elements CPE1, CPE2 and CPE3 from an input terminal through an output terminal. Further, a resistor R1 is connected parallel to the constant phase element CPE1 and a resistor R3 is connected parallel to the constant phase element CPE3, to thereby form the equivalent circuit.

In the equivalent circuit shown in FIG. 5, the resistor Rs corresponds to the electrolyte 133, the resistor R1 corresponds to the negative electrode 132, and the resistor R3 corresponds to the positive electrode 131.

By the alternating current impedance method, the resistances Rs, R1 and R3 can be respectively measured by applying alternating current to the equivalent circuit shown in FIG. 5 while changing frequency.

That is, in accordance with the alternating current impedance method, for example, the component deterioration measuring part 111 applies alternating current to the storage battery 103 and varies the frequency of the applied alternating current. Thus, the resistance values corresponding to the resistances of the electrolyte 133, the negative electrode 132 and the positive electrode 131 are measured as the resistances Rs, R1 and R3 of the equivalent circuit in FIG. 5.

As a specific method for carrying out the measurement by the alternating current impedance method, there can be mentioned a method in which the frequency is changed by the frequency response analyzer (FRA). Alternatively, however, the component deterioration measuring part 111 may measure the resistances of the components by, for example, an impedance measuring method using fast fourier transform as the alternating current impedance method etc. Further, the deterioration indices of the components measured by the component deterioration measuring part 111 may be resistances measured by a method other than the aforementioned alternating current impedance method.

### [Examples of deterioration condition determination]

Next, explanations are made with respect to one example of the deterioration condition determination process performed by the deterioration condition determination part 112.

As mentioned above, the component deterioration index measuring part 111 measures, as deterioration indices, respective resistances of the positive electrode 131, the negative electrode 132 and the electrolyte 133.

The deterioration condition determination part 112 sorts the components (i.e., the positive electrode 131, the negative electrode 132 and the electrolyte 133) into a target of the deterioration control and a non-target of the deterioration control, based on the resistances of the components measured as the deterioration conditions indices. That is, as a result of the determination of the deterioration, the deterioration condition determination part 112 sorts the components into a target of the deterioration control and a non-target of the deterioration control.

The component as the target of the deterioration control means a component which needs control to suppress the progress of deterioration, e.g., a component which is the most deteriorated among the positive electrode 131, the negative electrode 132, the electrolyte 133, etc.

On the other hand, the component as the non-target of the deterioration control means a component which does not need control to suppress the progress of deterioration, e.g., a component which is the least deteriorated among the positive electrode 131, the negative electrode 132, the electrolyte 133, etc..

First, as one examples of specific means for selecting a component as the target of the deterioration control, the deterioration condition determination part 112 may select as the target a component which has the highest resistance among the resistance values measured with respect to the positive electrode 131, the negative electrode 132 and the electrolyte 133.

However, the positive electrode 131, the negative electrode 132 and the electrolyte 133 do not necessarily have the same resistance which corresponds to the life of each component itself. Accordingly, a component as the target of the deterioration control may be selected as follows. That is, preset resistance values (upper limits of resistance) corresponding to the lives of the positive electrode 131, the negative electrode 132, the electrolyte 133, etc. are registered in the deterioration condition determination part 112. Here, the upper limits of resistance with respect to the positive electrode 131, the negative electrode 132, the electrolyte 133, etc. are known from a prior testing, a specification and the like of the storage battery 103.

Then, with respect to each of the positive electrode 131, the negative electrode 132 and the electrolyte 133, the deterioration condition determination part 112 obtains a ratio of the measured resistance value to the upper limit of resistance. The thus obtained ratio indicates the progress of deterioration. That is, the deterioration condition measuring part 112 determines the progress of deterioration with respect to each of the positive electrode 131, the negative electrode 132 and the electrolyte 133.

Based on the thus obtained progresses of deterioration, the deterioration condition measuring part 112 selects, as the target of the deterioration control, a component which is the most deteriorated among the positive electrode 131, the negative electrode 132 and the electrolyte 133.

Further, as one example of specific means for selecting a component as the non-target of the deterioration control, the deterioration condition determination part 112 may select as the non-target a component which has the lowest resistance among the resistance values measured with respect to the positive electrode 131, the negative electrode 132 and the electrolyte 133.

Alternatively, with respect to each of the positive electrode 131, the negative electrode 132 and the electrolyte 133, the deterioration condition determination part 112 obtains a ratio of the measured resistance value to the upper limit of resistance to determine the progress of deterioration. Based on the thus obtained progresses of deterioration, the deterioration condition measuring part 112 may select, as the non-target of the deterioration control, a component which is the least deteriorated among the positive electrode 131, the negative electrode 132 and the electrolyte 133.

### [Examples of operation condition determination]

Next, explanations are made with respect to one example of the operation condition determination process performed by the operation condition determination part 113.

As mentioned above, for determining the operation condition, the operation condition determination part 113 in this embodiment refers to the operation condition table recorded in the operation condition table recording part 114.

FIG. 6 shows an example of construction of an operation condition table.

The operation table shown in FIG. 6 has a construction where operation conditions are stored in correspondence with the combinations of the components (electrolyte 133, negative electrode 132 and positive electrode 131) as the targets of operation control with the components (electrolyte 133, negative electrode 132 and positive electrode 131) as the non-targets of operation control.

For example, when the deterioration condition determination part 112 selects the electrolyte 133 as the target of the deterioration control and the negative electrode 132 as the non-target of the deterioration control, the operation condition determination part 113 determines the operation condition as follows. The operation condition determination part 113 refers to the operation condition table and identifies an operation condition, as operation condition A, which is stored in correspondence with a combination of the electrolyte 133 as the target of the deterioration control and the negative electrode 132 as the non-target of the deterioration control. The operation condition determination part 113 outputs the thus identified operation condition A as a result of the determination.

### [Examples of operation control]

The operation condition table shows operation conditions which are respectively constructed to, as a top priority, suppress the progress of deterioration of the corresponding component as the target of the deterioration control without considering the suppression of the progress of deterioration of the corresponding component as the non-target of the deterioration control or with a consideration to avoid extreme deterioration of such a component as the non-target of the deterioration control.

The electrolyte 133 is, for example, one which has a characteristic that the deterioration thereof can be effectively suppressed by increasing the number of charge/discharge cycle per unit time and decreasing the storage time per the same unit time. In contrast, the negative electrode 132 is, for example, one which has a characteristic that the deterioration thereof can be effectively suppressed by decreasing the number of charge/discharge cycle per unit time and increasing the storage time per the same unit time.

In view of these, the operation condition A is, for example, one in which the number of charge/discharge cycle per unit time is kept at a certain level or higher and the storage time per the same unit time is kept at a certain level or lower.

The operation control part 115 operates the storage battery 103 such that the operation condition becomes as prescribed in the operation condition A in response to the determination of the operation condition A by the operation condition determination part 113. For example, the operation control part 115 loosely sets conditions such as condition for supplying power stored in the storage battery 103 to the load 106 and condition for charging the storage battery 103 with excessive amount of power generated by the solar cell 101 or excessive amount of power supplied from the commercial power supply AC. Thus, the number of charge/discharge cycle of the storage battery 103 can be increased and the storage time of the battery can be decreased.

By the control performed in this manner, in the storage battery 103, the deterioration of the electrolyte 133 which has deteriorated the most previously can be suppressed. On the other hand, with respect to the negative electrode 132 which has not so seriously deteriorated, for example, the deterioration may proceed without any effective measures taken to suppress the deterioration.

As a result, for example, when a certain period of time has passed, the progress of deterioration of the electrolyte 133 can be slowed down to a mild one as in the case of the deterioration of the negative electrode 132. As the operation control as mentioned above is repeated with a prescribed timing, for example, at regular time intervals, the deterioration progresses of the positive electrode 131, the negative electrode 132 and the electrolyte 133 become closer to those with which the longest battery life can be achieved.

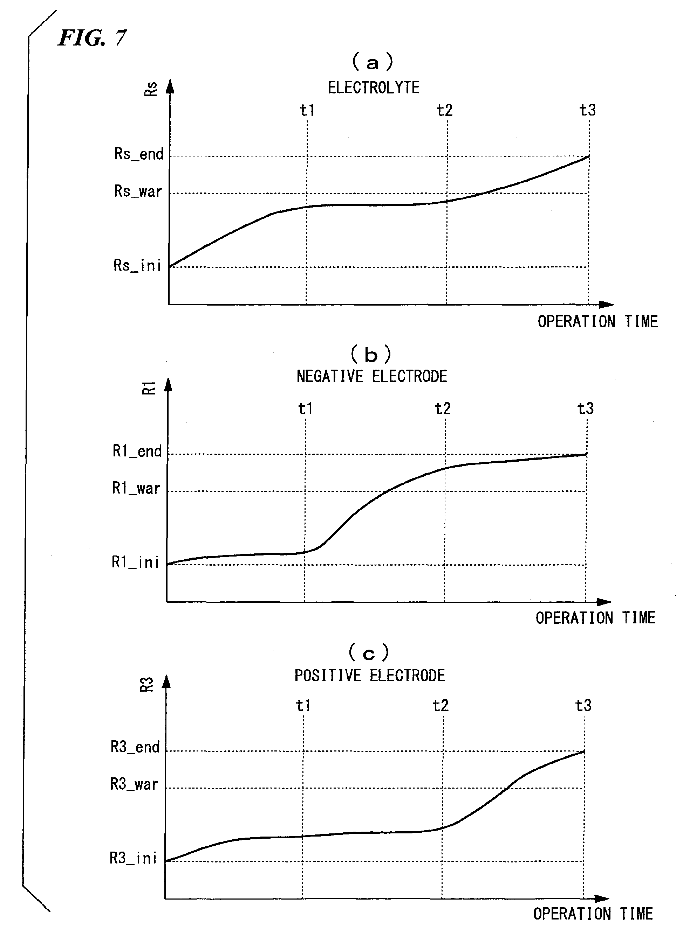

FIG. 7 shows an example of progress of deterioration of components (the positive electrode 131, the negative electrode 132 and the electrolyte 133) during operation control by the battery operation control apparatus according to the this embodiment.

FIG. 7(a) shows the progress of deterioration of the electrolyte 133, FIG. 7(b) shows the progress of deterioration of the negative electrode 132, and FIG. 7(c) shows the progress of deterioration of the positive electrode 131. In each of FIGs. 7(a), 7(b) and 7(c), the abscissa shows the operation times of the storage battery 103 and the ordinate shows the resistance values of the storage battery 103.

Further, in the ordinate in FIG. 7(a), "RS_ini" indicates an initial value, "RS_war" indicates a warning value, and "RS_end" indicates an end value, each obtained with respect to the electrolyte 133.

In the ordinate in FIG. 7(b), "R1_ini" indicates an initial value, "R1_war" indicates a warning value, and "R1_end" indicates an end value, each obtained with respect to the negative electrode 132.

In the ordinate in FIG. 7(c), "R3_ini" indicates an initial value, "R3_war" indicates a warning value, and "R3_end" indicates an end value, each obtained with respect to the positive electrode 131.

The initial values RS_ini, R1_ini and R3_ini are respectively the resistance values of the electrolyte 133, the negative electrode 132 and the positive electrode 131, each being measured before the storage battery 103 is used.

The warning values RS_war, R1_war and R3_war are respectively the resistance values of the electrolyte 133, the negative electrode 132 and the positive electrode 131, which correspond to the resistances when the lives of the electrolyte 133, the negative electrode 132 and the positive electrode 131 are close to their end. For example, the warning values RS_war, R1_war and R3_war may be set, respectively, as specific ratios relative to the end values RS_end, R1_end and R3_end. In operation with such a warning value setting, for example, when any of the resistances of the electrolyte 133, the negative electrode 132 and the positive electrode 131 exceeds the warning value, this indicates that the storage battery 103 should be replaced.

The end values RS_end, R1_end and R3_end are respectively the resistance values of the electrolyte 133, the negative electrode 132 and the positive electrode 131, which correspond to the resistances when the lives of the electrolyte 133, the negative electrode 132 and the positive electrode 131 have ended.

As apparent from comparison between FIGs. 7(a), 7(b) and 7(c), the degrees of resistance increase of the components before the time t1 in order from the lowest to the highest are : the electrolyte 133, the positive electrode 131 and the negative electrode 132 at times.

That is, the degrees of deterioration of the components before the time t1 in order from the lowest to the highest are: the electrolyte 133, the positive electrode 131 and the negative electrode 132.

In this situation, for example, when the battery operation control apparatus 107A performs an operation control at the time t1, the deterioration condition determination part 112 selects the electrolyte 133 as the target of the deterioration control and the negative electrode 132 as the non-target of the deterioration control. In response to this, after the time t1, the operation control part 115 switches the operation to prioritize the suppression of the deterioration of the electrolyte 133 while paying no particular attention to the deterioration of the negative electrode 132.

Thus, after the time t1, the deterioration of the electrolyte 133 is suppressed as shown in FIG. 7(a). On the other hand, the negative electrode 132 shifts to a state where the deterioration proceeds more after the time t1 as shown in FIG. 7(b). Then, when the time reaches the t2, the degrees of deterioration of the components in order from the highest to the lowest are: the negative electrode 132, the electrolyte 133 and the positive electrode 131. Especially, the deterioration of the negative electrode 132 has progressed to a level where the resistance reaches the warning value R1_war.

For example, the battery operation control apparatus 107A performs an operation control at the time t2 at which a certain period of time has passed since the time t1. At the time t2, the deterioration condition determination part 112 selects the negative electrode 132 as the target of the deterioration control and the positive electrode 131 as the non-target of the deterioration control. In response to this, after the time t2, the operation control part 115 switches the operation to prioritize the suppression of the deterioration of the negative electrode 132 while paying no particular attention to the deterioration of the positive electrode 131.

As a result, after the time t2, the degree of deterioration of the positive electrode 131 becomes higher while the degree of deterioration of the negative electrode 132 becomes lower as shown in FIG. 7(c). Then, for example, at the time t3 at which a certain period of time has passed since the time t2, the resistance values of the electrolyte 133, the negative electrode 132 and the positive electrode 131 almost reach the end values RS_end, R1_end and R3_end, respectively.

In FIG. 7, for the sake of easy explanation, there is shown an example where the operation control is performed only twice at the times t1 and t2 over the period of from the initiation of operation of the storage battery 103 until the end of the battery life. However, when the operation control is performed more frequently with shorter intervals over the period of from the initiation of operation of the storage battery 103 until the end of the battery life, the storage battery 103 can be operated while bringing the deterioration progresses of the electrolyte 133, the negative electrode 132 and the positive electrode 131 closer to those at which the battery life can be extended the most.

The life of the storage battery 103 ends when the resistance of at least one of the components such as the electrolyte 133, the negative electrode 132 and the positive electrode 131 becomes the end value. Therefore, when the battery operation is continued under conditions such that any one of the electrolyte 133, the negative electrode 132 and the positive electrode 131 deteriorates at an extremely high rate, the life of the storage battery 103 is shortened accordingly.

On the other hand, in this embodiment of the present invention, as mentioned above, the storage battery 103 can be operated while bringing the deterioration progresses of the electrolyte 133, the negative electrode 132 and the positive electrode 131 closer to those at which the life of the storage battery can be extended the most. Therefore, it becomes possible to prevent only a part of the electrolyte 133, the negative electrode 132 and the positive electrode 131 of the storage battery 103 from deteriorating more rapidly than the other components, whereby the life of the storage battery 103 can be extended.

### [Examples of procedures]

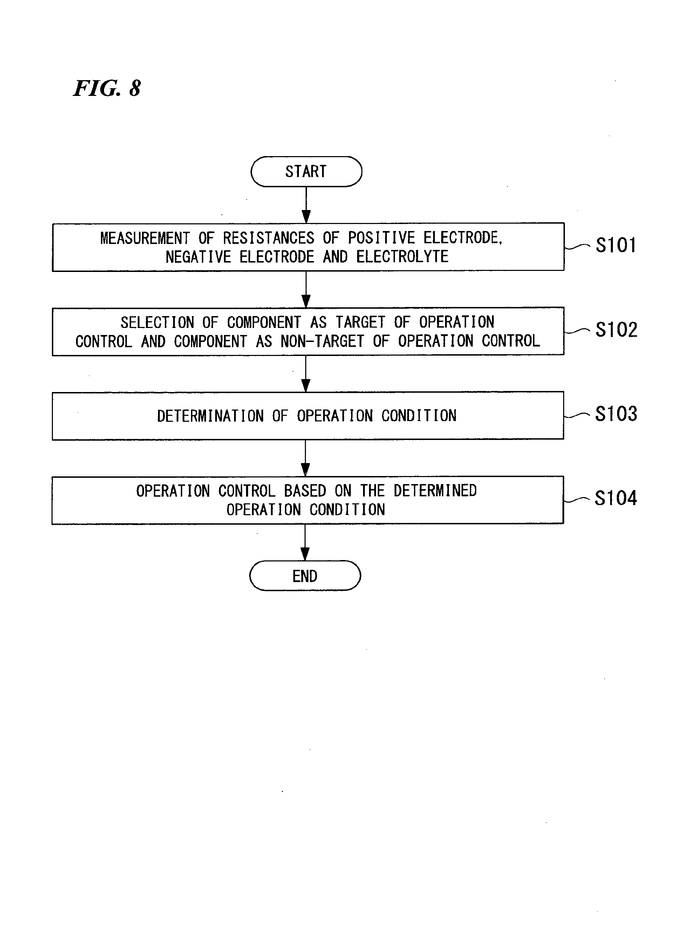

FIG. 8 is a flowchart showing an example of procedures implemented by the battery operation control apparatus 107A. With respect to each of the procedures shown in FIG. 8, for example, it may be performed at predetermined specific time intervals or in response to an operation by a user as an administrator for instructing the switch of operation conditions.

First, the component deterioration index measuring part 111 measures, as resistances (impedances) of the storage battery 103, resistance values corresponding to the positive electrode 131, the negative electrode 132 and the electrolyte 133 in accordance with the alternating current impedance method, etc. (Step S101).

Then, the deterioration condition measuring part 112 determines the deterioration condition with respect to each of the positive electrode 131, the negative electrode 132 and the electrolyte 133. That is, the deterioration condition determination part 112 sorts the components (i.e., the positive electrode 131, the negative electrode 132 and the electrolyte 133) into a target of the deterioration control and a non-target of the deterioration control, based on the resistance values of the components measured in step S101 (step S102).

Next, the operation condition determination part 113 determines the operation condition (Step S103). That is, the operation condition determination part 113 refers to the operation condition table and identifies an operation condition which is stored in correspondence with a combination of a component as the target of the deterioration control and a component as the non-target of the deterioration control which are sorted in step S102. The identified operation condition is output as a determination result.

Then, the operation control part 115 operates the storage battery 103 based on the operation condition determined in step S103 (Step S104).

The above explanations on the procedures of the operation control in accordance with the first embodiment are merely for the purpose of exemplification. For example, in the control table shown in FIG. 6, operation conditions are set such that a component with the highest degree of deterioration is combined with a component with the lowest degree of deterioration.

However, for example, a more simple setting may be employed in order to most effectively suppress the deterioration of a component which is the most deteriorated. In such a case, the control table may have a construction where one operation is correlated with each of the components such as the positive electrode 131, the negative electrode 132 and the electrolyte 133.

Further, the operation conditions may be set such that the suppression of deterioration of the most deteriorated component among the positive electrode 131, the negative electrode 132 and the electrolyte 133 is prioritized, and the deterioration of the second most deteriorated component is also suppressed to some extent.

### <Second embodiment>

### [Example of construction of battery operation control apparatus]

Next, explanations are made with respect to the second embodiment of the present invention. With respect to the construction of a power management system according to the second embodiment of the present invention, for example, the construction may be the same as in FIG. 1.

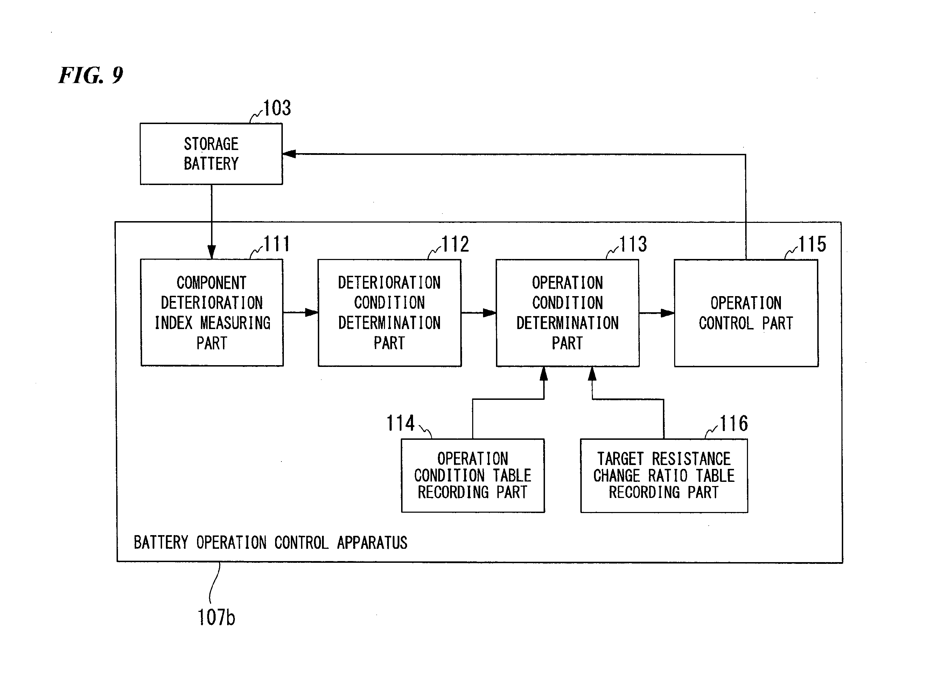

FIG. 9 shows an example of construction of the battery operation control apparatus 107B according to the second embodiment of the present invention. In FIG. 9, the same parts as in FIG. 2 are designated by the same reference numerals as in FIG. 2.

As shown in FIG. 9, the battery operation control apparatus 107B further has a target change ratio table recording part 116 in addition to the construction of the battery control operation apparatus 107A.

The target change ratio table recording part 116 records the target change ratio table. As to the target change ratio table, explanations will be made later.

Further, as explained below, in the case of the battery operation control apparatus 107B according to the second embodiment of the present invention, the procedures for deterioration index measurement by the deterioration index measuring part 111, deterioration condition determination by the deterioration condition determination part 112 and operation condition determination by the operation condition determination part 113 are different from those in the first embodiment.

Furthermore, as explained below, in the second embodiment of the present invention, the contents recorded by the operation condition table recording part 114 are different from those in the first embodiment.

### [Examples of deterioration index measurement]

What are measured as deterioration indices by the component deterioration index measuring part 111 in the second embodiment are resistances of the positive electrode 131, the negative electrode 132 and the electrolyte 133. Further, for measuring respective resistances of the positive electrode 131, the negative electrode 132 and the electrolyte 133, the component deterioration index measuring part 111 employs the alternating current impedance method. In these respects, the second embodiment is the same as the first embodiment.

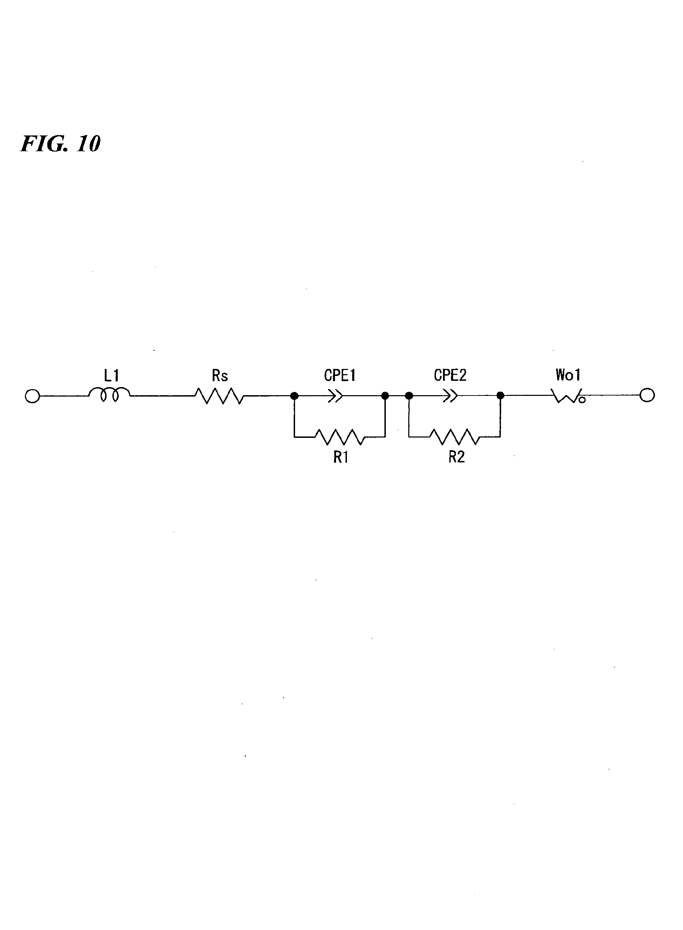

However, for measuring respective resistances of the positive electrode 131, the negative electrode 132 and the electrolyte 133 by the alternating current impedance method, the component deterioration index measuring part 111 employs the equivalent circuit shown in FIG. 10 instead of the equivalent circuit shown in FIG. 5.

The equivalent circuit shown in FIG. 10 serially connects an inductance LI, a resistor Rs, constant phase elements CPE 1, CPE2 and a diffused resistor Wo1 from an input terminal through an output terminal. Further, a resistor R1 is connected parallel to the constant phase element CPE1 and a resistor R2 is connected parallel to the constant phase element CPE2, to thereby form the equivalent circuit. The diffused resistor Wo1 is a resistor which is designed to function with diffusion in an electrolytic solution of lithium ions.

In the equivalent circuit having a construction as mentioned above, the resistor Rs corresponds to the electrolyte 133, the resistor R1 corresponds to the negative electrode 132, and the resistor R2 corresponds to the positive electrode 131.

In the second embodiment, in accordance with the alternating current impedance method, the component deterioration measuring part 111 applies alternating current to the storage battery 103 and varies the frequency of the applied alternating current, to thereby measure the resistance values of the resistors Rs, R1 and R2 of the equivalent circuit shown in FIG. 10. Thus, the resistances corresponding to the electrolyte 133, the negative electrode 132 and the positive electrode 131 are measured as the resistances Rs, R1 and R2 of the equivalent circuit in FIG. 10.

### [Examples of deterioration condition determination]

Next, explanations are made with respect to the deterioration condition determination part 112 of the second embodiment of the present invention.

The deterioration condition determination part 112 in the second embodiment records the resistances Rs, R1 and R2 of the electrolyte 133, the negative electrode 132 and the positive electrode 131 of the storage battery 103 prior to use (new battery) as the initial resistance values Rs_i, R1_i and R2_i.

The initial resistance values Rs_i, R1_i and R2_i can be measured by the component deterioration measuring part 111 with respect to the storage battery 103 prior to use, or may be resistance values Rs_i, R1_i and R2_i prior to use which are included in the specifications of the storage battery 103.

With respect to the resistance values Rs, R1 and R2 measured by the component deterioration measuring part 111 at a specific time after commencement of the use of the battery, the deterioration condition determination part 112 obtains respective amounts of resistance change ΔRs, ΔR1 and ΔR2 relative to the initial resistance values Rs_i, R1_i and R2_i.

Specifically, the deterioration condition determination part 112 can perform determination of the amount of resistance change ΔRs by the following calculation : ΔRs = Rs - Rs_i, determination of the amount of resistance changeΔR1 by the following calculation : ΔR1 = R1 - R1_i, and determination of the amount of resistance change ΔR2 by the following calculation : ΔR2 = R2 - R2_i.

The resistance values Rs, R1 and R2 corresponding to the electrolyte 133, the negative electrode 132 and the positive electrode 131 increase from the corresponding initial resistance values R2_i, R1_i and R2_i as the deterioration proceeds.

Therefore, the amounts of resistance change ΔRs, ΔR1 and ΔR2 respectively represent the degrees of deterioration of the electrolyte 133, the negative electrode 132 and the positive electrode 131. That is, the amounts of resistance change ΔRs, ΔR1 and ΔR2 respectively represent the results of the deterioration determination with respect to the components of the storage battery 103, i.e., the electrolyte 133, the negative electrode 132 and the positive electrode 131.

### [Operation condition table]

Next, explanations are made with respect to the operation condition table recorded in the operation condition table recording part 114 in the second embodiment of the present invention.

The operation condition table recorded in the operation condition table recording part 114 is prepared based on the test results obtained by a preliminary operation test.

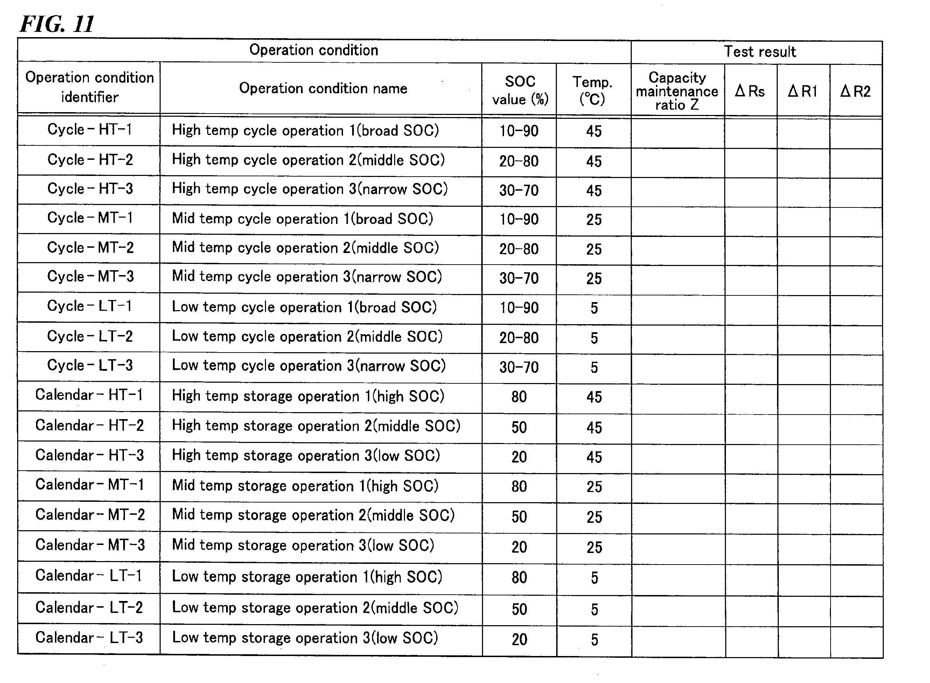

The preliminary operation test for preparation of the operation condition table may be, for example, a test wherein a battery having the same specifications as the storage battery 103 is operated under a plurality of prescribed conditions as shown in FIG. 11. FIG. 11 shows as one example a case where eighteen (18) operation conditions are prescribed.

The operation conditions shown in FIG. 11 shows operation condition identifiers, operation condition names, state of charge (SOC) values and temperatures.

The operation condition identifier is an identifier which uniquely identifies a corresponding operation condition.

The operation condition name is a name given to a corresponding operation condition.

The SOC value is an SOC applied to a corresponding operation condition. The SOC means an amount of electricity stored which is dependent on the electricity stored in the storage battery.

The temperature is a temperature of the storage battery. The temperature of the storage battery depends on the ambient temperature, the amount of electricity received by or discharged from the battery, and the like.

For example, in FIG. 11, the "High temperature cycle operation 1" with the operation condition identifier "Cycle-HT-1" is an operation condition wherein a cycle operation (charge/discharge) with a broad SOC (10 % to 90 %) is performed at a high temperature (45 °C).

The "High temperature cycle operation 2" with the operation condition identifier "Cycle-HT-2" is an operation condition wherein a cycle operation with a modestly broad SOC (20 % to 80 %) is performed at a high temperature (45 °C).

The "High temperature cycle operation 3" with the operation condition identifier "Cycle-HT-3" is an operation condition wherein a cycle operation with a narrow SOC (30 % to 70 %) is performed at a high temperature (45 °C).

Further, the "Middle temperature cycle operation 1" with the operation condition identifier "Cycle-MT-1" is an operation condition wherein a cycle operation with a broad SOC (10 % to 90 %) is performed at a middle temperature (25 °C).

Furthermore, the "Low temperature cycle operation 1" with the operation condition identifier "Cycle-LT-1" is an operation condition wherein a cycle operation with a broad SOC (10 % to 90 %) is performed at a low temperature (5 °C).

The "High temperature storage operation 1" with the operation condition identifier "Calendar-HT-1" is an operation condition wherein a storage operation with a high SOC (80 %) is performed at a high temperature (45 °C).

The "High temperature storage operation 2" with the operation condition identifier "Calendar-HT-2" is an operation condition wherein a storage operation with a middle SOC (50 %) is performed at a high temperature (45 °C).

The "High temperature storage operation 3" with the operation condition identifier "Calendar-HT-3" is an operation condition wherein a storage operation with a low SOC (20 %) is performed at a high temperature (45 °C).

The "Middle temperature storage operation 1" with the operation condition identifier "Calendar-MT-1" is an operation condition wherein a storage operation with a high SOC (80 %) is performed at a middle temperature (25 °C).

The "Low temperature storage operation 1" with the operation condition identifier "Calendar-LT-1" is an operation condition wherein a storage operation with a high SOC (80 %) is performed at a low temperature (5 °C).

For example, a test apparatus (not shown) implements cycle tests for predetermined cycles following the nine (9) operation conditions for cycle operation out of the eighteen (18) operation conditions shown in FIG. 11. The test apparatus implements the cycle tests to, for example, measure the resistance values Rs, R1 and R1 with respect to the electrolyte 133, the negative electrode 132 and the positive electrode 131 at each charge/discharge cycle, and obtain the amounts of resistance change ΔRs, ΔR1 and ΔR2. Further, while implementing the cycle tests, the test apparatus determines the capacity maintenance ratio Z at each charge/discharge cycle.

The capacity maintenance ratio is a ratio of the post-initial maximum capacity to the initial maximum capacity wherein the maximum capacity is the maximum amount of electricity that can be stored in the battery and the post-initial maximum capacity is measured after the measurement of the initial maximum capacity. The maximum amount of electricity which can be stored in the storage battery decreases as the deterioration of the storage battery progresses due to the use thereof. Accordingly, the capacity maintenance ratio Z also decreases as the deterioration of the storage battery progresses.

Similarly, the test apparatus implements maintenance tests for predetermined period of time following the nine (9) operation conditions for storage operation shown in FIG. 11. While implementing the maintenance tests, for example, the test apparatus measures the resistance values Rs, R1 and R1 with respect to the electrolyte 133, the negative electrode 132 and the positive electrode 131 at predetermined time intervals, and obtains the amounts of resistance change ΔRs, ΔR1 and ΔR2. Further, while implementing the maintenance tests, the test apparatus determines the capacity maintenance ratio Z at predetermined time intervals.

Then, as results of the tests implemented as mentioned above following the eighteen (18) operation conditions, the test apparatus records the values of the capacity maintenance ratio Z and the amounts of resistance change ΔRs, ΔR1 and ΔR2 while correlating these with the eighteen (18) operation conditions.

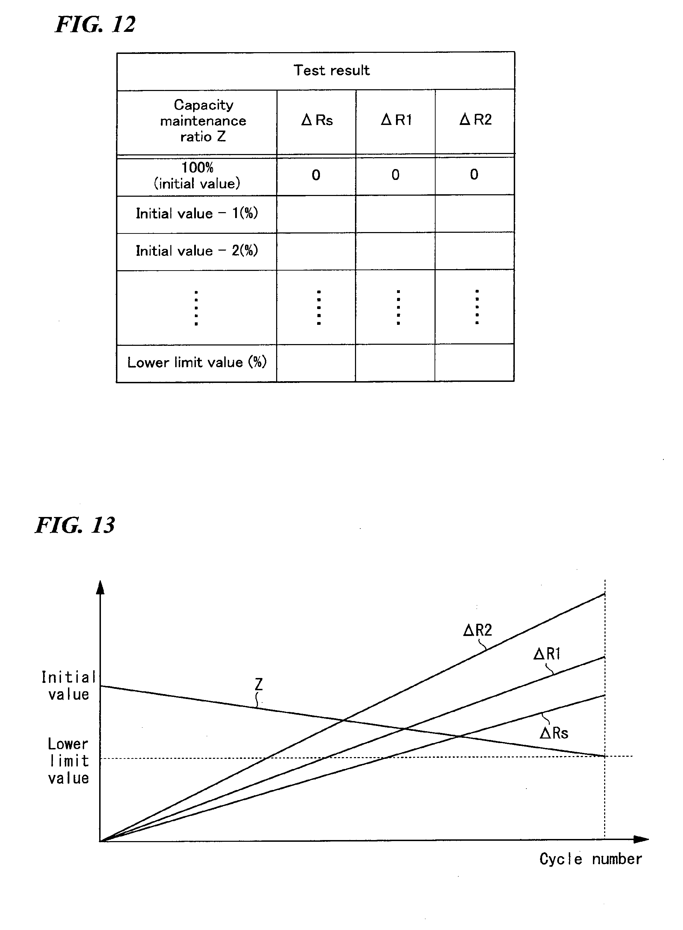

Here, as shown in FIG. 12, the test results corresponding to one operation condition shown in FIG. 11 are constructed to correlate the values of capacity maintenance ratio Z sorted into classes ranging from the initial value to the lower limit value with the amounts of resistance change ΔRs, ΔR1 and ΔR2.

FIG. 12 shows an example where the values of the capacity maintenance ratio Z are sorted into classes with a difference of 1% in the Z value between each class. The lower limit of the capacity maintenance ratio Z is a value measured with respect to the storage battery which has reached the end of its life.

FIG. 13 shows the results of measurements of the capacity maintenance ratio Z and the amounts of resistance change ΔRs, ΔR1 and ΔR2, which are performed following a certain one of the operation conditions for cycle operation.

As shown in FIG. 13, the amounts of resistance change ΔRs, ΔR1 and ΔR2 of the electrolyte 133, the negative electrode 132 and the positive electrode 131 increase as the cycle number increases, following respective different tendencies. Further, the capacity maintenance ratios Z decrease as the components deteriorate.

When the cycle tests and the maintenance tests are finished before the measurement of the capacity maintenance ratio Z, the test apparatus records the measured values per se as the test results with respect to the capacity maintenance ratio Z and the amounts of resistance change ΔRs, ΔR1 and ΔR2. Then, the test apparatus may record, as the test results, the values obtained by simulation with respect to the capacity maintenance ratio Z values including unmeasured values ranging to the lower limit value and the amounts of resistance change ΔRs, ΔR1 and ΔR2 corresponding to the capacity maintenance ratio Z values.

The operation condition table in the second embodiment is prepared as follows, based on the test results obtained in correspondence with the operation conditions as shown in FIG.11.

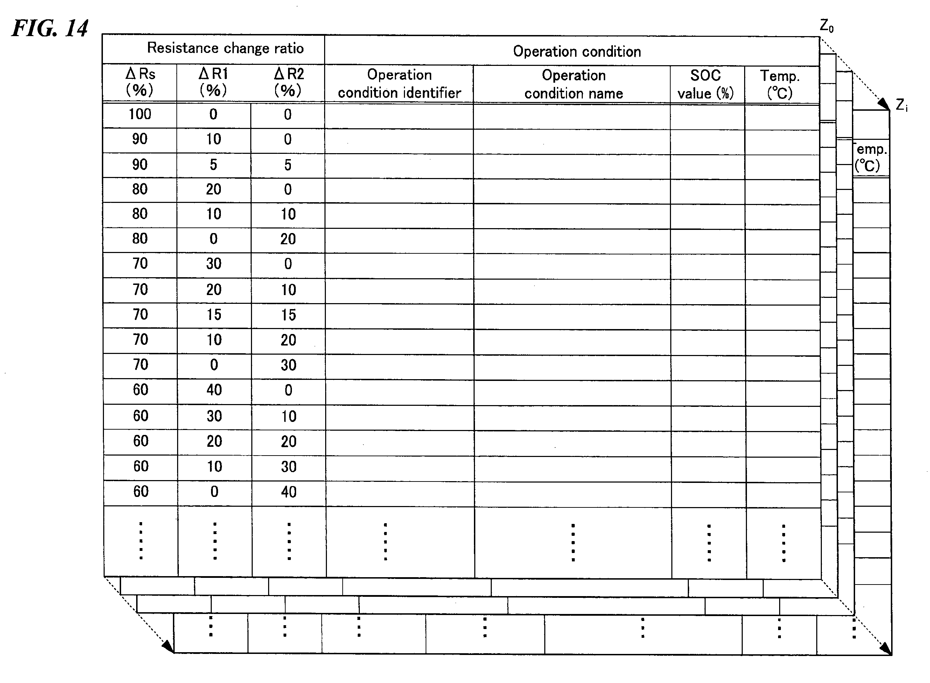

FIG. 14 shows an example of construction of an operation condition table according to the second embodiment of the present invention.

The operation condition table shown in FIG. 14 contains separate tables for different capacity maintenance ratios, i.e., the Z values Z₀ to Zᵢ within a specific range chosen out of a range of from 100 % to the lower limit value. Each one of the separated tables for different capacity maintenance ratios has a structure wherein an operation conditions is correlated to each of different patterns of the capacity change ratio.

For preparing one of the separate tables for different capacity maintenance ratios, a plurality of different patterns of the capacity change ratio are determined and stored.

For example, in the operation condition table shown in FIG. 14, the ratio between ΔRs, ΔR1 and ΔR2 as the capacity change ratio in the first line is as follows:
ΔRs : ΔR1 : ΔR2 = 100% : 0% : 0%, and
   the capacity change ratio in the second line is as follows:
ΔRs : ΔR1 : ΔR2 = 90% : 10% : 0%.

With respect to the pattern of the amounts of the resistance change, the separate tables for different capacity maintenance ratios may contain the same pattern.

Then, one operation condition is correlated to each of the patterns of the amounts of resistance change in each one of the separate tables for the capacity maintenance ratios as follows.

For example, an operation table generating apparatus (not shown) such as a computer obtains the amounts of resistance change ΔRs, ΔR1 and ΔR2 correlated with the capacity maintenance ratio Z corresponding to the one of the separate tables for different capacity maintenance ratios to be prepared, from the test results corresponding to the eighteen (18) operation conditions which are as shown in FIGs. 11 and 12.

The operation table generating apparatus converts the combinations of the amounts of resistance change ΔRs, ΔR1 and ΔR2 which respectively correspond to the eighteen (18) operation conditions into respective ratios (resistance change ratios). The operation table generating apparatus correlates one of the eighteen (18) operation conditions with each of the resistance change ratios in a corresponding one of the separate tables for different capacity maintenance ratios, based on the resistance change ratios (ratios between the amounts of resistance change ΔRs, ΔR1 and ΔR2) with respect to the eighteen (18) operation conditions.

For correlating the above-mentioned values, for example, the operation condition table generating apparatus identifies, from the resistance change ratios corresponding to the eighteen (18) operation conditions, the closest resistance change ratio with respect to each of the resistance change ratios in the separate tables for different capacity maintenance ratios. The operation condition corresponding to the identified resistance change ratio is correlated to the resistance change ratio.

As a result of correlating the values, each of the separate tables for different capacity maintenance ratios is caused to store the operation condition identifier of the operation condition correlated with the resistance change ratio, the name of the operation condition, the SOC value and the temperature (see FIG. 11) in correspondence with each of the resistance change ratios.

Thus, one of the separate tables for different capacity maintenance ratios is prepared. The operation table generating apparatus integrates the separate tables for different capacity maintenance ratios Z₀ to Zᵢ into the operation condition table.

The thus prepared operation condition table shows a resistance change ratio to be obtained under a certain operation condition with respect to each of the capacity maintenance ratios Z₀ to Zᵢ.

Then, the prepared operation condition table is recorded in the operation condition table recording part 114 of the battery operation control apparatus 107B shown in FIG. 9.

### [Target resistance change ratio table]

The target resistance change ratio table recorded in the target resistance change ratio table recording part 116, for example, has a construction (not shown) wherein the resistance change ratio (ratio between the amounts of resistance change ΔRs, ΔR1 and ΔR2) is correlated to such conditions of the cycle operation and the storage operation that the deterioration progresses the least, with respect to each of the capacity maintenance ratios.

Such a target resistance change ratio table is prepared as follows, based on the results of the tests implemented for obtaining the test results shown in FIG.11.

For example, when the operations are performed under conditions shown in FIG. 11, the cycle number and the storage time at the same capacity maintenance ratio vary depending on the operation conditions. Accordingly, the target resistance change ratio table stores the resistance change ratio obtained in a test performed under a cycle operation condition where the cycle number is the smallest and the resistance change ratio obtained in a test performed under a storage operation condition where the storage time is the shortest.

### [Examples of procedures]

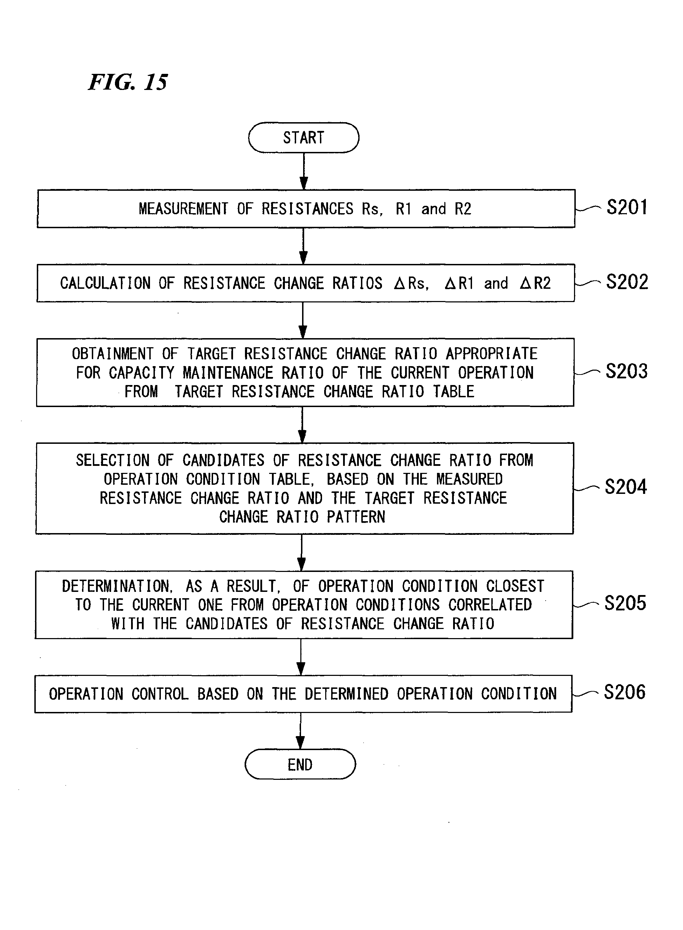

Next, explanations are made with respect to the procedures for operation control implemented by the battery operation control apparatus 107B of the second embodiment of the present invention. With respect to each of the procedures shown in FIG. 15, for example, it may be performed at predetermined specific time intervals or in response to an operation by a user as an administrator for instructing the switch of operation conditions.

The component deterioration index measuring part 111 measures, as resistances of the storage battery 103, resistance values Rs, R1 and R2 corresponding to the positive electrode 131, the negative electrode 132 and the electrolyte 133 by, for example, the alternating current impedance method using the equivalent circuit shown in FIG. 10 (Step S201).

Then, the deterioration condition measuring part 112 determines the deterioration condition with respect to each of the positive electrode 131, the negative electrode 132 and the electrolyte 133. That is, the deterioration condition determination part 112 calculates the amounts of resistance change ΔRs, ΔR1 and ΔR2 corresponding to the resistance values Rs, R1 and R2 of the positive electrode 131, the negative electrode 132 and the electrolyte 133 which are measured in step S201 (Step S202). The thus calculated amounts of resistance change ΔRs, ΔR1 and ΔR2 are the results of deterioration condition determination with respect to the positive electrode 131, the negative electrode 132 and the electrolyte 133.

Then, for determining the operation condition, the operation condition determination part 113 refers to the target resistance change ratio table recorded in the target resistance change ratio table recording part 116, and obtains a target resistance change ratio corresponding to the capacity maintenance ratio Z at a specific time during the battery operation from the target resistance change ratio table (Step S203).

For determining the capacity maintenance ratio Z at a specific time during the battery operation, for example, the latest measurement results can be relied upon in the case where the capacity maintenance ratio Z is measured periodically during the battery operation. When the measurement of the capacity maintenance ratio Z is not implemented during the battery operation, the capacity maintenance ratio Z presumed by a simulation based on the operation history may be used.

Then, the operation condition determination part 113 selects candidates of the resistance change ratio from the operation condition table recorded in the operation condition table recording part 114, based on the resistance change ratio between the amounts of resistance change ΔRs, ΔR1 and ΔR2 which are measured in step S202, and the target resistance change ratio obtained in step S203 (Step S204).

As an example, there can be mentioned a case where the measured resistance change ratio ΔRs : ΔR1 : ΔR2 = 20% : 40% : 40% while the target resistance change ratio = 60% : 20% : 20%, and the operation condition determination part 113 selects the candidates of the resistance change ratio as follows.

First, regarding the percentage of the amount of resistance change ΔRs, the measured value is 20% whereas the target value is 60% which is higher than the measured value. In this case, the deterioration is suppressed more than needed in the electrolytic solution; therefore, the percentage of the amount of resistance change ΔRs of the electrolytic solution should be increased from 20% to 60%. In such a case, it is preferred to operate the storage battery under conditions such that the percentage of the amount of resistance change ΔRs exceeds 60%.

Also in the case of the percentage of the amount of resistance change ΔR1, the measured value is 40% whereas the target value is 20%, namely, the measured value is higher than the target value. In this case, for bringing the deterioration progress of the negative electrode close to the state where the deterioration is the most suppressed, the percentage of the amount of resistance change ΔR1 should be decreased from 40% to 20%. In such a case, it is preferred to operate the storage battery under conditions such that the percentage of the amount of resistance change ΔR1 becomes less than 20%.

Similarly, with respect to the percentage of the amount of the resistance change ΔR2, the measured value is 40% whereas the target value is 20%, so that it is preferred to operate the storage battery under conditions such that the percentage of the amount of resistance change ΔR2 becomes less than 20%.

That is, concerning the resistance change ratio, it is preferred to satisfy the conditions wherein the percentage of the amount of the resistance change ΔRs exceeds 60%, the percentage of the amount of the resistance change ΔR1 becomes less than 20%, and the percentage of the amount of the resistance change ΔR2 becomes less than 20%.

Accordingly, the operation condition determination part 113 selects a resistance change ratio satisfying the above-mentioned conditions from the operation condition table shown in FIG. 14. Specifically, the operation condition determination part 113 selects the following four (4) resistance change ratios: ΔRs : ΔR1 : ΔR2 = 100% : 0% : 0%, ΔRs : ΔR1 : ΔR2 = 90% : 5% : 5%, ΔRs : ΔR1 : ΔR2 = 80% : 10% : 10%, and ΔRs : ΔR1 : ΔR2 = 70% : 15% : 15%. The thus selected resistance change ratios are the candidates of the resistance change ratio.

When the operation conditions specified include those for the cycle operation and the storage operation as in the case of the operation condition table shown in FIG. 14, the operation condition determination part 113 may select the candidates of the resistance change ratio with respect to each of the cycle operation and the storage operation in step S204.

Then, the operation condition determination part 113 selects, as a result of the determination, an operation condition closest to an ongoing operation condition from the operation conditions correlated in the operation condition table to the candidates of the resistance change ratio which are selected in step S204 (Step S205).

In this instance, when the candidates of the resistance change ratios corresponding to the cycle operation and the storage operation are selected in step S204, one operation condition for each of the cycle operation and the storage operation in step S205 may be selected as the determination result.

Then, the operation control part 115 operates the storage battery based on the operation condition determined in step S205 (Step S206).

In this instance, when one operation condition is determined for each of the cycle operation and the storage operation in step S205, the operation control part 115 may perform operation control based on the operation condition determined for the cycle operation during the cycle operation, and may perform operation control based on the operation condition determined for the storage operation during the storage operation.

The explanations above are made on the case where the storage battery 103 is a lithium ion battery; however, the storage battery 103 may be a battery other than a lithium ion battery.

The components used in the present invention may include any other than the positive electrode, the negative electrode and the electrolyte.

In the present invention, the functions of each part can be performed by a method in which a program for implementing the functions is recorded in a computer-readable recording medium, and the program recorded in this medium is loaded into a computer system and implemented. Herein, the "computer system" may embrace the operating system (OS) and the hardware such as peripheral devices.

The computer system using network may embrace a homepage provider environment (or a homepage display environment).

The "computer-readable recording media" may encompass flexible disks, magneto-optic disks, ROM, portable media such as CD-ROM, and other storage devices such as hard-disk units installed in computers. Additionally, the computer-readable recording media may encompass storage means, which is able to retain programs for a certain period of time, such as internal volatile memory (RAM) of computers acting as servers or clients when the programs are transmitted through networks (e.g. the Internet) or communication lines (e.g. telephone lines). The aforementioned program may be one for implementing a part of the functions mentioned above, or may be one which can implement the functions when combined with a program already recorded in the computer system.

Various embodiments of the present invention are explained above referring to the drawings; however, the specific construction is not limited to those of the embodiments and may be altered as long as the alterations do not deviate from the gist of the present invention.

### DESCRIPTION OF THE REFERENCE SIGNS

- 100: Facility
- 101: Solar cell
- 102: Power conditioning system
- 103: Storage battery
- 104: Inverter
- 105: Power path switching portion
- 106: Load
- 107: Power management apparatus
- 107A, 107B: Battery operation control apparatus
- 111: Component deterioration index measuring part
- 112: Deterioration condition determination part
- 113: Operation condition determination part
- 114: Operation condition table recording part
- 115: Operation control part
- 131: Positive electrode
- 132: Negative electrode
- 133: Electrolyte

## Claims

1. An apparatus for controlling operation of a storage battery, comprising:
a component deterioration index measuring part, which measures a deterioration index with respect to each of predetermined components of a storage battery,
a deterioration condition determination part, which determines deterioration condition with respect to each of the predetermined components, based on the deterioration indices of the components measured by the component deterioration index measuring part,
an operation condition determination part, which determines such an operation condition of the storage battery as would cause deterioration of each component to progress in a manner such that the longest battery life is achieved, based on the deterioration conditions determined by the deterioration determination part, and
an operation control part for operating the storage battery based on the operation condition determined by the operation condition determination part.

2. The apparatus according to claim 1, wherein the components of the storage battery are a positive electrode, a negative electrode and an electrolyte.

3. The apparatus according to claim 1 or 2, wherein:
the component deterioration index measuring part measures resistance with respect to each of the components,
the deterioration condition determination part sorts the components into a target of the deterioration control and a non-target of the deterioration control as determination of deterioration conditions of the components, based on the resistances of the components measured by the component deterioration index measuring part, and
the operation condition determination part identifies an operation condition correlated with a combination of the component as target of the deterioration control and the component as non-target of the deterioration control, which are determined by the deterioration condition determination part, based on an operation condition table which correlates each combination of the component as target of the deterioration control and the component as non-target of the determination control with an operation condition, wherein the identified operation condition is regarded as the result of the determination.

4. The apparatus according to claim 1 or 2, wherein:
the component deterioration index measuring part measures resistances of the storage battery with respect to the components;
the deterioration condition determination part determines an amount of resistance change from the initial value, as the deterioration condition of each of the components, with respect to the resistance of each of the components measured by the component deterioration index measuring part; and
the operation condition determination part, referring to an operation condition table showing correlations between operation conditions and resistance change ratios obtainable under the respective operation conditions, selects from the table candidates of the resistance change ratio at which the degree of deterioration of each component is such that the life of the battery is extended, based on resistance change ratios each being a ratio of the amounts of resistance change of the components determined by the deterioration condition determination part, and a resistance change ratio corresponding to such an operation condition of the storage battery that the longest battery life is achieved, and selects an operation condition, as a determination result, which is the closest to an ongoing operation condition, from the operation conditions correlated to the candidates of the resistance change ratio.

5. A method for controlling an operation of a storage battery, comprising:
a component deterioration index measuring step for measuring a deterioration index with respect to each of predetermined components of a storage battery,
a deterioration condition determination step for determining deterioration condition with respect to each of the predetermined components, based on the deterioration indices of the components measured in the component deterioration index measuring step,
an operation condition determination step for determining an operation condition of the storage battery at which the degree of deterioration of each of the components is such that the longest battery life is achieved, based on the deterioration conditions determined in the deterioration condition determination step, and
an operation control step for operating the storage battery based on the operation condition determined in the operation condition determination step.

6. A computer program for implementing:
a component deterioration index measuring step for measuring a deterioration index with respect to each of predetermined components of a storage battery,
a deterioration condition determination step for determining deterioration condition with respect to each of the predetermined components, based on the deterioration indices of the components measured in the component deterioration index measuring step,
an operation condition determination step for determining an operation condition of the storage battery at which the degree of deterioration of each of the components is such that the longest battery life is achieved, based on the deterioration conditions determined in the deterioration condition determination step, and
an operation control step for operating the storage battery based on the operation condition determined in the operation condition determination step.
